(19) **Europäisches Patentamt**

**European Patent Office**

**Office européen des brevets**

(11) **EP 1 198 890 B1**

(12) **EUROPÄISCHE PATENTSCHRIFT**

(45) Veröffentlichungstag und Bekanntmachung des Hinweises auf die Patenterteilung:
**29.01.2003 Patentblatt 2003/05**

(21) Anmeldenummer: **00958177.8**

(22) Anmeldetag: **27.07.2000**

(51) Int Cl.⁷: **H03M 13/00**

(86) Internationale Anmeldenummer:
**PCT/DE00/02468**

(87) Internationale Veröffentlichungsnummer:
**WO 01/010039 (08.02.2001 Gazette 2001/06)**

(54) **VERFAHREN ZUM ERZEUGEN VON ZUVERLÄSSIGKEITSINFORMATIONEN FÜR DIE KANALDECODIERUNG IN EINEM FUNKEMPFÄNGER SOWIE ENTSPRECHENDER FUNKEMPFÄNGER**

METHOD FOR GENERATING RELIABILITY INFORMATION FOR THE DECODING CHANNEL OF A RADIO RECEIVER AND CORRESPONDING RADIO RECEIVER

PROCEDE DE PRODUCTION D'INFORMATIONS DE FIABILITE DESTINEES AU DECODAGE DE CANAL DANS UN RECEPTEUR RADIO ET RECEPTEUR RADIO CORRESPONDANT

(84) Benannte Vertragsstaaten:
**AT BE CH CY DE DK ES FI FR GB GR IE IT LI LU MC NL PT SE**

(30) Priorität: **29.07.1999 DE 19935824**

(43) Veröffentlichungstag der Anmeldung:
**24.04.2002 Patentblatt 2002/17**

(73) Patentinhaber: **Infineon Technologies AG 81669 München (DE)**

(72) Erfinder:
• **HARTMANN, Ralf**
  **D-81377 München (DE)**
• **BOHNHOFF, Peter**
  **D-81667 München (DE)**

(74) Vertreter: **Banzer, Hans-Jörg, Dipl.-Ing. et al Kraus & Weisert Patent- und Rechtsanwälte Thomas-Wimmer-Ring 15 80539 München (DE)**

(56) Entgegenhaltungen:
**EP-A- 0 843 444**          **EP-A- 1 065 851**
**US-A- 5 307 374**

• **MÜLLER S H ET AL: "Reduced-state soft-output trellis-equalization incorporating soft feedback" IEEE GLOBECOM, 18. November 1996 (1996-11-18), XP002096661**
• **KOCH W ET AL: "OPTIMUM AND SUB-OPTIMUM DETECTION OF CODED DATA DISTURBED BY TIME- VARYING INTERSYMBOL INTERFERENCE" PROCEEDINGS OF THE GLOBAL TELECOMMUNICATIONS CONFERENCE AND EXHIBITION(GLOBECOM),US,NEW YORK, IEEE, Bd. -, 2. Dezember 1990 (1990-12-02), Seiten 1679-1684, XP000218858 ISBN: 0-87942-632-2 in der Anmeldung erwähnt**
• **HAGENAUER J ET AL: "A VITERBI ALGORITHM WITH SOFT-DECISION OUTPUTS AND ITS APPLICATIONS" PROCEEDINGS OF THE GLOBAL TELECOMMUNICATIONS CONFERENCE AND EXHIBITION(GLOBECOM),US,NEW YORK, IEEE, Bd. -, 27. November 1989 (1989-11-27), Seiten 1680-1686, XP000091258 in der Anmeldung erwähnt**

**Beschreibung**

Die vorliegende Erfindung betrifft ein Verfahren zum Erzeugen von Zuverlässigkeitsinformationen für den Kanaldecodierer eines Funkempfängers, insbesondere eines Mobilfunkempfängers, sowie einen entsprechenden Funkempfänger.

Übertragungskanäle in Mobilfunksystemen sind durch ihren zeitabhängigen Mehrwege-Empfang charakterisiert, der bei digitalen Übertragungssystemen zu Intersymbol-Interferenzen führt. Um derartige Intersymbol-Interferenzen bewältigen zu können, ist empfangsseitig eine Entzerrung der empfangenen Daten erforderlich. Sendeseitig werden die zu übertragenden Daten aufgrund der sich schnell ändernden Übertragungsbedingungen sowie zur Unterdrückung von Nachbarkanal- und Gleichkanalstörungen in zellularen Netzen verwürfelt (Interleaving) und kanalcodiert übertragen.

Zur empfangsseitigen Kanaldecodierung sind Informationen wünschenswert, welche die Zuverlässigkeit der von dem Entzerrer durchgeführten Entzerrung angeben. Bei diesen Zuverlässigkeitsinformationen handelt es sich um Informationen, .welche durch eine sogenannte Soft Decision gewonnen werden. Im Gegensatz zu einer Hard Decision, bei der lediglich eine feste Entscheidungsschwelle verwendet wird, wird bei einer Soft Decision eine Vielzahl von Entscheidungsschwellen verwendet und somit die Entscheidungssicherheit deutlich erhöht. Entzerrer, wie sie beispielsweise in GSM-Empfängern eingesetzt werden und auch gemäß der zukünftigen Erweiterung des GSM-Mobilfunkstandards, EDGE, vorgesehen sind, müssen daher einerseits das Empfangssignal ausreichend entzerren andererseits die zuvor beschriebenen Zuverlässigkeitsinformationen bereitstellen.

Zur Erzeugung der zuvor genannten Zuverlässigkeitsinformationen sind viele unterschiedliche Verfahren bekannt, wobei in Mobilfunksystemen häufig Algorithmen verwendet werden, die auf einer sogenannten 'Maximum Likelihood Sequence Estimation (MLSE)' beruhen, wie sie z.B. in "Digital Communications", Proakis, J.G., McGraw-Hill, New York, 1983, beschrieben ist. Die verbreitetste Implemetierung dieses Verfahrens ist der Viterbi-Algorithmus, bei dem mit Hilfe von Trellis-Diagrammen die zuvor erwähnten Zuverlässigkeitsinformationen in Form von Wahrscheinlichkeiten dafür gewonnen werden, ob ein empfangenes Symbol auf einer gesendeten '0' oder einer gesendeten '1' beruht.

Da dieser (optimale) Algorithmus jedoch sehr komplex und demzufolge sehr rechenaufwendig ist und einen sehr großen Speicherplatz erfordert, wurden verschiedene suboptimale Verfahren entwickelt, die auf einfachere Art und Weise Zuverlässigkeitsinformationen für den Kanaldecodierer zur Verfügung stellen.

Ein derartiges suboptimales Verfahren ist u.a. in "Optimum And Sub-Optimum Detection Of Coded Data Disturbed By Time-Varying Intersymbol Interference", Wolfgang Koch und Alfred Baier, 1990 IEEE, beschrieben. Gemäß diesem als 'Reduced State Soft Decision Equalizer' bezeichneten Verfahren, welches einem Verfahren nach dem Oberbegriff des Anspruches 1 entspricht, werden die Zuverlässigkeitsinformationen in dem Entzerrer Symbol für Symbol generiert. Der entsprechende Algorithmus ist zu einem Hard Decision Viterbi-Algorithmus sehr ähnlich, erzeugt jedoch die Zuverlässigkeitsinformationen auf deutlich einfachere Art und Weise, wobei zu einem Zeitpunkt $\mu$ die Zuverlässigkeitsinformation für ein empfangenes Symbol zum Zeitpunkt $\mu$-L ermittelt wird. Dabei bezeichnet L die Länge des Beobachtungszeitraums und entspricht mindestens der Länge der Kanalimpulsantwort des Übertragungskanals. Die Zuverlässigkeitsinformation wird ermittelt, indem anhand eines Trellis-Diagramms der beste 'Einspfad' des Trellis-Diagramms, d.h. der beste oder günstigste Pfad mit dem Wert '1' zum Zeitpunkt $\mu$-L, und der beste 'Nullpfad', d.h. der beste oder günstigste Pfad mit dem Wert '1' zum Zeitpunkt $\mu$-L, ermittelt wird. Die Ermittlung dieser beiden Pfade des Trellis-Diagramms erfolgt anhand von Metriken, welche für die einzelnen Zustandsübergänge in dem Trellis-Diagramm berechnet werden. Dabei wird insbesondere die sogenannte Matched-Filter-Metrik angewendet. Die Zuverlässigkeitsinformation wird schließlich dadurch erhalten, daß die auf diese Weise für den besten 'Einspfad' und den besten 'Nullpfad' berechneten Metriken zueinander in Beziehung gesetzt werden. Um den Rechenaufwand und den Speicherbedarf zu reduzieren, wird zur Berechnung der einzelnen Metriken eine Trellis mit einer reduzierten Anzahl an Zuständen verwendet. Nur für die Elemente 0...L' (L' < L) der Kanalimpulsantwort wird eine trellisbasierte Entzerrung gestartet, während die übrigen Elemente L'+1...L lediglich entscheidungsrückgekoppelt in die trellisbasierte Entzerrung eingehen. Die Grundlagen dieser Entscheidungsrückkopplung ('Decision Feedback Sequence Estimation') können beispielsweise dem Aufsatz "Reduced-State Sequence Estimation With Set Partitioning And Decision Feedback", Vedat Eyuboglu und Shahid Qureshi, 1988 IEEE, entnommen werden.

Bei der zuvor beschriebene Vorgehensweise muß der Entzerrer zu jedem Zeitpunkt $\mu$ den auf den Zeitpunkt $\mu$-L' bezogenen besten Eins- und Nullpfad ermitteln und daraus die Zuverlässigkeitsinformation für das empfangene Symbol zum Zeitpunkt $\mu$-L' berechnen. In die Zweigmetriken gehen dabei einerseits Bits zu den Zeitpunkten $\mu$...$\mu$-L' und Bits zu den Zeitpunkten $\mu$-L'-1...$\mu$-L ein, wobei die letztgenannten Bits, wie bereits beschrieben, als Entscheidungsrückkopplung in die Metrikberechnung eingehen. Diese letztgenannten Bits ergeben sich aus den einzelnen sogenannten 'Survivor'-Pfaden der $2^{L'}$-Zustände des Trellis-Diagramms, d.h. den jeweils kostengünstigsten und wahrscheinlichsten Zustandsübergängen, die jedoch demzufolge von Zustand zu Zustand verschieden sind, so daß ein entsprechend hoher Rechenaufwand und Speicherbedarf erforderlich ist, da der Entzerrer zu jedem Zeitpunkt $\mu$ eine

Liste mit $2^{L'}$ Zuständen führen muß.

Der vorliegenden Erfindung liegt daher die Aufgabe zugrunde, ein Verfahren zum Erzeugen von Zuverlässigkeitsinformationen für die Kanaldecodierung in einem Funkempfänger sowie einen entsprechenden Funkempfänger bereitzustellen, womit der Berechnungsaufwand und der dafür benötigte Speicherplatz reduziert werden kann.

Diese Aufgabe wird erfindungsgemäß durch ein Verfahren mit den Merkmalen des Anspruches 1 bzw. einen Funkempfänger mit den Merkmalen des Anspruches 9 gelöst. Die Unteransprüche definieren jeweils bevorzugte und vorteilhafte Ausführungsformen der vorliegenden Erfindung.

Die vorliegende Erfindung basiert auf der in "Optimum And Sub-Optimum Detection Of Coded Data Disturbed By Time-Varying Intersymbol Interference", Wolfgang Koch und Alfred Baier, 1990 IEEE, beschriebenen und zuvor erläuterten Vorgehensweise. Erfindungsgemäß werden die in Form einer Entscheidungsrückkopplung berücksichtigten Bits jedoch nicht mehr zustandsabhängig in einer Liste geführt, sondern für die Entscheidungsrückkopplung gehen Symbole in die Berechnung ein, welche bereits zuvor entschieden worden sind, d.h. diese Bits oder Symbole sind für alle $2^{L'}$ Zustände identisch.

Zur Entscheidung dieser Symbole, d.h. zur Ermittlung des beispielsweise binären Werts dieser Symbole, wird zu jedem Zeitpunkt $\mu$ aus dem besten Null- und Einspfad eine Zuverlässigkeitsinformation für das Symbol zum Zeitpunkt $\mu$-L' erzeugt, mit Hilfe einer Hard Decision in ein Bit mit entsprechendem Wert umgewandelt und während der nächsten L-L' folgenden Zeitpunkte bei der Berechnung der einzelnen Metriken weiterverwendet.

Die vorliegende Erfindung, welche insbesondere zur Entzerrung von Intersymbol-Interferenzen in Mobilfunksystemen gemäß dem GSM-, DCS1800- oder PCAS1900-Standard einsetzbar ist, besitzt den großen Vorteil, daß der Implementierungsaufwand sowohl bei einer hardwaremäßgen Realisierung als auch bei einer Realisierung auf einem digitalen Signalprozessor deutlich reduziert werden kann, da für die entscheidungsrückgekoppelten Bits keine aufwendigen Felder geführt werden müssen, sondern lediglich L-L' Variablen genügen, die nur einmal pro Symbolausgabe aktualisiert werden müssen, so daß sowohl Speicherplatz als auch Rechenleistung und somit elektrische Energie eingespart werden kann. Umfangreiche Simulationen (die beispielsweise für L' = 2 auf einer GSM-Downlink-Strecke durchgeführt worden sind) haben zudem bewiesen, daß für die in der sogenannten GSM-Recommendation 05 angegebenen Kanalmodelle keine spürbare Verschlechterung der Bitfehlerrate festzustellen ist.

Die vorliegende Erfindung wird nachfolgend näher unter Bezugnahme auf die beigefügte Zeichnung erläutert.

Fig. 1 zeigt ein Mobilfunk-Übertragungsmodell in Form eines einfachen Blockschaltbilds,

Fig. 2 zeigt ein Modell des Kanals des in Fig. 1 gezeigten Mobilfunksystems, und

Fig. 3A und 3B zeigen Darstellungen zur Erläuterung der Metrikberechnung in einem Trellis-Diagramm.

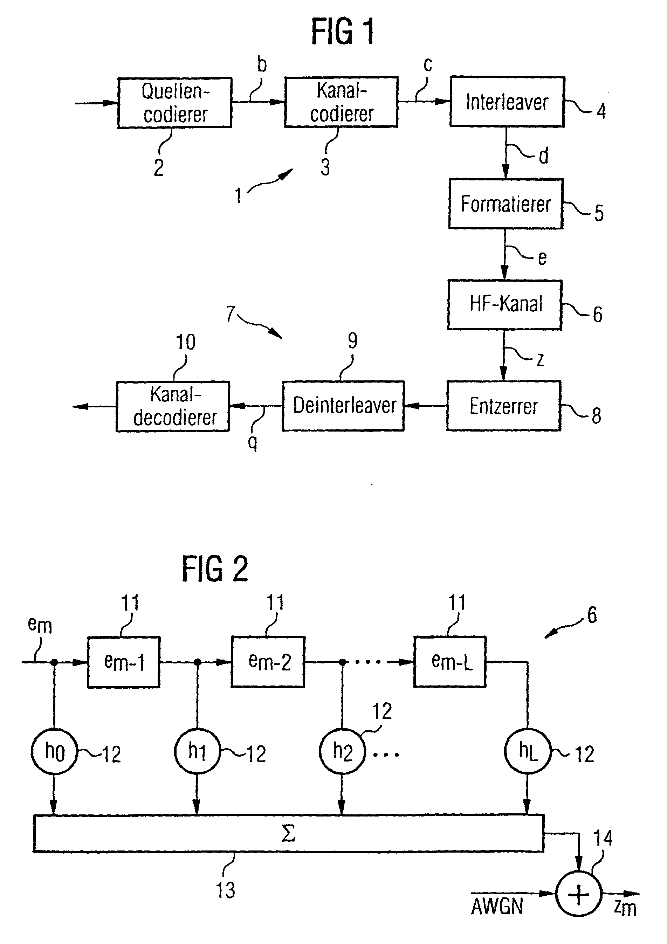

Zur Herleitung und Erläuterung des der vorliegenden Erfindung zugrundeliegenden Prinzips wird nachfolgend auf die bereits erwähnte Druckschrift "Optimum And Sub-Optimum Detection Of Coded Data Disturbed By Time-Varying Intersymbol Interference", Wolfgang Koch und Alfred Baier, 1990 IEEE, und insbesondere auf das in Fig. 1 gezeigte Übertragungsmodell eines Mobilfunksystems Bezug genommen, wobei ein Mobilfunksender 1 und ein Mobilfunkempfänger 7 dargestellt sind, welche über einen Kanal 6 miteinander kommunizieren.

In dem Sender 1 werden zu übertragende Informationen, beispielsweise Sprachinformationen, von einem Quellencodierer 2 zunächst in ein digitales Signal, d.h. in eine Folge von '1'und '0'-Symbolen, umgesetzt und in Form von quellencodierten Datenwörtern oder Datenvektoren b ausgegeben, deren einzelnen Elemente oder Symbolen jeweils den Wert '1' oder '0' aufweisen. Von einem Kanalcodierer 3 wird jedes Datenwort b in ein Codewort c abgebildet, dessen Symbole von einem Interleaver 4 permutiert, d.h. verwürfelt werden. Idealerweise erfolgt das Interleaving derart, daß beliebige zwei Symbole eines Codeworts c auf zwei unterschiedliche Ausgangswörter d des Interleavers 4 abgebildet werden. Der Formatierer 5 fügt schließlich am Anfang und Ende jedes Datenworts d des Interleavers 4 L bekannte Symbole (sogenannte Tail-Symbole) an, um einen definierten Anfangs- und Endzustands des nachfolgend näher erläuterten Modells des Kanals vorzugeben. Von dem Formatierer 5 werden somit Sendewörter oder Sendevektoren e mit e = $(e_{1-L}, \dots, e1, e2, \dots, e_M)$ und M = I+L ausgegeben, wobei I die Länge der von dem Interleaver 4 ausgegebenen Datenwörter d bezeichnet.

Der in Fig. 1 gezeigte Kanal 6 umfaßt u.a. den Modulator und Verstärker des Senders, den eigentlichen HF-Kanal (Übertragungskanal) sowie die Vorempfangsstufe, das EIngangsfilter und den A/D-Wandler des Empfängers und kann durch das in Fig. 2 gezeigte Kanalmodell dargestellt werden. Das Kanalmodell entspricht einer Zustandsmaschine mit L Speicherstufen, deren einzelnen zwischengespeicherten Sendesymbole $e_m \dots e_{m-L}$ über Multiplizierer 12 mit Hilfe eines Addierers 13 addiert werden. Die Koeffizienten $h_0 \dots h_L$ entsprechen den Koeffizienten der Kanalimpulsantwort. In dem Modell ist auch das im Übertragungskanal auftretende Rauschen in Form des additiven weißen Gaußrauschens (AWGN) berücksichtigt, welches mit Hilfe eines Addierers 14 das Ausgangssignal des Addierers 13 überlagert, so daß schließlich ein Empfangssymbol $z_m$ des Empfängers erhalten wird.

Im Empfänger 7 besitzen der Entzerrer 8, der Deinterleaver 9 und der Kanaldecodierer 10 gemeinsam die Aufgabe, anhand der Empfangssequenz z die ursprüngliche Sendesequenz b mit größtmöglicher Zuverlässigkeit z bestimmen. Dazu werden mit Hilfe einer Soft Decision Zuverlässigkeitsinformationen für den Kanaldecodierer 10 erzeugt, welche für jedes empfangene Symbol die a-priori-Wahrscheinlichkeit angeben, daß das empfangene Symbol auf einer gesendeten '0' oder '1' beruht.

Zu Erzeugung dieser Zuverlässigkeitsinformationen wird das in Fig. 2 gezeigte Kanalmodell durch ein entsprechendes Trellis-Diagramm dargestellt, welches das Verhalten des Kanals in Form von Zustandsübergängen beschreibt. Die Trellis gibt dabei für jeden augenblicklichen Zustand des Kanals in Abhängigkeit von einem neuen Symbol $e_m$ den neuen Zustand an, wobei nachfolgend ein Trelliszustand zum Zeitpunkt $\mu$ mit $S_\mu$ bezeichnet wird und durch $S_\mu = (e_{\mu-L+1}, ..., e_\mu)$ definiert ist.

Jedem Zustandswechsel $S_{\mu-1} \rightarrow S_\mu$ kann ein metrisches Inkrement zugewiesen werden, welches dann später zur Beurteilung der Wahrscheinlichkeit dieses Zustandswechsels ausgewertet wird und durch die folgende Formel definiert ist:

$$\lambda(S_{\mu-1}, S_\mu) = \left| z_\mu - \sum_{l=0}^{L} e_{\mu-l} h_l \right|^2 \div \sigma^2 \qquad (1)$$

Satt dessen kann auch die sogenannte Matched-Filter-Metrik, wie sie z.B. in "Digital Communications", Proakis, J.G., McGraw-Hill, New York, 1983, beschrieben ist, verwendet werden:

$$\lambda(S_{\mu-1}, S_\mu) = -\text{Re}\left\{ e_\mu \left( y_\mu - \sum_{l=1}^{L} e_{\mu-l} h_l \right) \right\} \div \sigma^2 \qquad (2)$$

Der Ausdruck

$$y_\mu = \sum_{l=0}^{L} z_{\mu+l} h_l \qquad (3)$$

bezeichnet den Ausgangswert des Matched Filters zum Zeitpunkt $\mu$, und der Ausdruck

$$\rho_l = \sum_{i=0}^{L-1} h_{i+l} h_i, \text{ für } l = 0...L \qquad (4)$$

bezeichnet den 1-ten Abtastwert der Autokorrelationsfunktion der Kanalimpulsantwort. Die vorliegende Erfindung ist jedoch nicht auf die Verwendung der Matched-Filter-Metrik beschränkt.

Unter Verwendung der oben beschriebenen Metrikformel (2) kann nunmehr die dem in Fig. 2 gezeigten Kanal 6 entsprechende Trellis ausgewertet werden, um zu jedem Zustand $S_\mu$ für jeden Trellis- oder Zeitschritt $\mu$ entsprechende Wahrscheinlichkeiten zu berechnen. Dabei wird idealerweise die Trellis sowohl in Rückwärts- als auch in Vorwärtsrichtung durchlaufen. Nachfolgend soll der Algorithmus zur Verarbeitung eines Empfangsworts z näher erläutert werden.

Beim Rückwärtsdurchlaufen der Trellis kann für jeden Trellisschritt $\mu$ von $\mu = M$ bis $\mu = L$ sowie für jeden Trelliszustand $S_\mu$ eine Rückwärtsmetrik $\Lambda_b(S_\mu)$ unter Verwendung der folgenden Rekursion berechnet werden:

$$\Lambda_b(S_{\mu-1}) = -\ln\left\{ \exp\left( -\Lambda_b(S'_\mu) - \lambda(S_{\mu-1}, S'_\mu) \right) + \exp\left( -\Lambda_b(S''_\mu) - \lambda(S_{\mu-1}, S''_\mu) \right) \right\} \qquad (5)$$

Die beiden Zustände $S'_\mu$ und $S''_\mu$ sind durch den Zustand $S_{\mu-1}$ bei Vorliegen des Zustandswerts $e_\mu = 1$ bzw. $e_\mu = 0$ definiert.

Auf analoge Art und Weise kann für jeden Trelliszustand $S_\mu$ eine Vorwärtsmetrik $\Lambda_b(S_\mu)$ unter Verwendung der folgenden Rekursion berechnet werden:

$$\Lambda_f(S_\mu) = -\ln\left\{\exp\left(-\Lambda_f(S'_{\mu-1}) - \lambda(S'_{\mu-1}, S_\mu)\right) + \exp\left(-\Lambda_f(S''_{\mu-1}) - \lambda(S''_{\mu-1}, S_\mu)\right)\right\} \quad (6)$$

In diesem Fall sind die beiden Zustände $S'_{\mu-1}$ und $S''_{\mu-1}$ durch den Zustand $S_\mu$ bei Vorliegen des Zustandswerts $e_{\mu-L} = 1$ bzw. $e_{\mu-L} = 0$ definiert.

Für jeden Zustandsübergang $S_{\mu-1} \to S_\mu$ der Trellis können nunmehr die Metriken $\Lambda_f(S_{\mu-1})$, $\lambda(S_{\mu-1}, S_\mu)$ und $\Lambda_b(S_\mu)$ addiert und ihre inversen Exponentiale über sämtliche Zustände $S_\mu$ getrennt für $e_{\mu-L} = 0$ und $e_{\mu-L} = 1$ aufaddiert werden:

$$u(e_{\mu-L}) = -\ln\left\{\sum_{S_\mu}\exp(-\Lambda_f(S_{\mu-1}) - \lambda(S_{\mu-1}, S_\mu) - \Lambda_b(S_\mu))\right\} \quad (7)$$

Mit Hilfe des in der Formel (7) dargestellten Ausdrucks kann schließlich zum Zeitpunkt $\mu$ ein Soft Decision-Wert $q(e_{\mu-L})$ für das Bit $e_{\mu-L}$ berechnet werden, indem die anhand der Formel (7) berechneten Werte für $e_{\mu-L} = 1$ und $e_{\mu-L} = 0$ zueinander in Beziehhung gesetzt werden:

$$q(e_{\mu-L}) = u(e_{\mu-L} = 1) - u(e_{\mu-L} = 0) \quad (8)$$

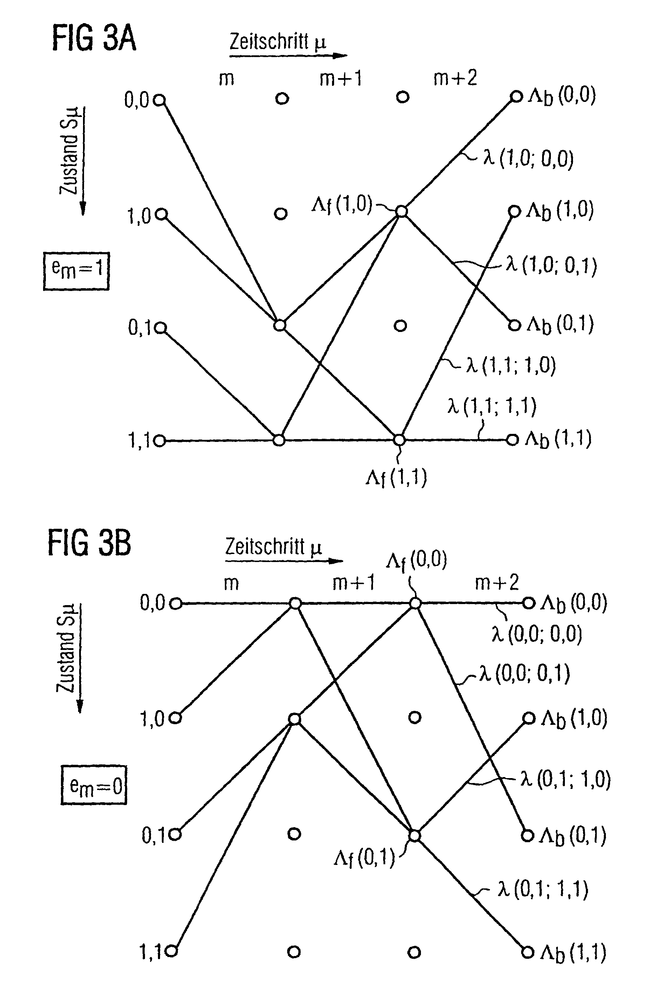

Zur Verdeutlichung der obigen Formel (7) ist in Fig. 3A ein Ausschnitt der dem in Fig. 2 gezeigten Kanalmodell zugeordneten Trellis für $L = 2$ und $e_m = 1$ dargestellt, während in Fig. 3B ein Ausschnitt derselben Trellis für $e_m = 0$ dargestellt ist. Dabei sind sowohl in Fig. 3A als auch in Fig. 3B lediglich diejenigen Pfade der Trellis dargestellt, welche bei diesem Beispiel zu der Summe der Formel (7) beitragen. Des weiteren sind in Fig. 3A und 3B jeweils die Metriken $\Lambda_b(S_{\mu-1})$, $\lambda(S_{\mu-1}, S_\mu)$ und $\Lambda_b(S_\mu)$ eingetragen.

Da mit Hilfe der oben beschriebenen Vorgehensweise optimale Soft Decision-Werte als Zuverlässigkeitsinformationen für die Kanaldecodierung gewonnen werden können, wird dieser Algorithmus in "Optimum And Sub-Optimum Detection Of Coded Data Disturbed By Time-Varying Intersymbol Interference", Wolfgang Koch und Alfred Baier, 1990 IEEE, als 'Optimum Soft Decision Equalization Algorithm (OSDE)' bezeichnet.

Da jedoch dieser Algorithmus viel Speicherplatz und einen großen Rechenaufwand erfordert, besteht das Bedürfnis nach einem vereinfachten Algorithmus, dessen Komplexität einerseits deutlich reduziert ist und der andererseits dennoch möglichst genaue Zuverlässigkeitsinformationen liefert.

Diesbzüglich wird in "Optimum And Sub-Optimum Detection Of Coded Data Disturbed By Time-Varying Intersymbol Interference", Wolfgang Koch und Alfred Baier, 1990 IEEE, zunächst vorgeschlagen, in der Formel (7) die Exponentialberechnungen zu vereinfachen. Die Formel (7) enthält allgemein einen Ausdruck der Form $-\ln(e^{-x}+e^{-y})$, wobei. jedoch für derartige Ausdrücke die folgende Beziehung gilt:

$$-\ln(e^{-x} + e^{-y}) = \min(x,y) - \ln(1 + e^{-|y-x|}) \quad (9)$$

Für $x \ll y$ und $x \gg y$ kann somit der Ausdruck $-\ln(e^{-x}+e^{-y})$ mit vernachlässigbarem Fehler durch die Minimalwertbildung $\min(x,y)$ angenähert werden. Eine weitere Vereinfachung kann erzielt werden, wenn auf das Rückwärtsdurchlaufen der Trellis verzichtet und somit in der Formel (7) die Metriken $\Lambda_b(S_\mu)$ für sämtliche Zustände $S_\mu$ auf 0 gesetzt werden.

Die Berechnung der Zuverlässigkeitsinformation zum Zeitpunkt $\mu$ für den Zeitpunkt $\mu-L$ gemäß Formel (8) vereinfacht sich somit wie folgt:

$$q(e_{\mu-L}) = \min_{S_\mu | e_{\mu-L}=1} (\Lambda_f(S_{\mu-1}) + \lambda(S_{\mu-1}, S_\mu)) - \min_{S_\mu | e_{\mu-L}=0} (\Lambda_f(S_{\mu-1}) + \lambda(S_{\mu-1}, S_\mu)) \qquad (10)$$

Der wesentliche Unterschied zum klassischen Viterbi-Algorithmus besteht somit lediglich darin, daß zur Berechnung der Soft Decision-Werte $q(e_{\mu-L})$ nur die Auswahl von zwei Minimalwerten aus einer Menge von $2^L$ Metriken erforderlich ist. In "Optimum And Sub-Optimum Detection Of Coded Data Disturbed By Time-Varying Intersymbol Interference", Wolfgang Koch und Alfred Baier, 1990 IEEE, wird dieser Algorithmus daher als 'Soft Decision Viterbi Equalizer (SDVE)' bezeichnet.

Eine weitere Vereinfachung kann erzielt werden, wenn dieser SDVE-Algorithmus mit $2^L$-Zuständen durch einen SDVE-Algorithmus mit einer reduzierten Zustandsanzahl $2^{L'}$ der Trellis mit L' < L ersetzt wird. Für die obige Formel (2) zur Berechnung der Matched-Filter-Metriken ergibt sich dann der folgende Ausdruck:

$$\lambda'(S_{\mu-1}, S_\mu) = -\text{Re}\left\{ e_\mu \left( y_\mu - \sum_{l=1}^{L'} e_{\mu-1}\rho_l - \sum_{l=L'+1}^{L} e'_{\mu-1}\rho_l \right) \right\} \div \sigma^2 \qquad (11)$$

Die Bits $e_{\mu-1}$ für l = 1...L' repräsentieren dann wie bei dem obigen Algorithmus die Zustandsbits des Zustands $S_{\mu-1}$. Darüber hinaus ist nunmehr die Berechnung der Matched-Filter-Metriken auch noch von einer zweiten Gruppe von Bits $e'_{\mu-1}$ für l = L'+1...L abhängig, welche nicht direkt in die trellisbasierte Entzerrung eingehen; vielmehr handelt es sich bei diesen Bits um entscheidungsrückgekoppelte Bits.

Während in "Optimum And Sub-Optimum Detection Of Coded Data Disturbed By Time-Varying Intersymbol Interference", Wolfgang Koch und Alfred Baier, 1990 IEEE, bezüglich dieser Gruppe von entscheidungsrückgekoppelten Bits vorgeschlagen wird, die Bits $e'_{\mu-1}$ für l = L'+1...L anhand der sogenannten 'Survivor'-Pfade für die $2^{L'}$-Zustände der Trellis zu bestimmen (vgl. die obige Beschreibung), wird im Rahmen der vorliegenden Erfindung vorgeschlagen, hierfür keine zustandsabhängigen Bits zu verwenden, sondern es werden zuvor entschiedene Bits, d.h. Symbole, deren Wert zuvor auf '0' oder '1' festgelegt worden ist, verwendet, welche für sämtliche $2^{L'}$ Zustände denselben Wert besitzen.

Diese entscheidungsrückgekoppelten Bits $e'_{\mu-1}$ für l = L'+1...L können dadurch gewonnen werden, daß zu jedem Zeitpunkt $\mu$ wie üblich aus dem besten Null- und dem besten Einspfad eine Zuverlässigkeitsinformation für das Symbol zum Zeitpunkt $\mu$-L' ermittelt wird. Diese Zuverlässigkeitsinformation wird mit einer festen Entscheidungsschwelle, d.h. mit Hilfe einer Hard Decision, in ein Bit mit dem Wert 0 oder 1 umgesetzt und als entscheidungsrückgekoppeltes Bit ('Decision Feedback') für die weiteren L-L' Zeitpunkte verwendet. Die Bits $e'_{\mu-L'-1}...e'_{\mu-L}$ sind somit für alle $2^{L'}$-Zustände konstant, wodurch ein geringerer Speicherplatz und Rechenaufwand zur Berechnung der Matched-Filter-Metriken gemäß Formel (10) erforderlich ist. Eine Abwandlung der obigen Formeln ist zur Durchführung der vorliegenden Erfindung nicht erforderlich.

Die Soft Decision-Zuverlässigkeitsinformation $q(e_{\mu-L'})$ kann dann analog zu obiger Formel (10) berechnet werden, wenn in die Formel (10) der Ausruck gemäß Formel (11) eingesetzt wird:

$$q(e_{\mu-L'}) = \min_{S_\mu | e_{\mu-L'}=1} (\Lambda_f(S_{\mu-1}) + \lambda'(S_{\mu-1}, S_\mu)) - \min_{S_\mu | e_{\mu-L'}=0} (\Lambda_f(S_{\mu-1}) + \lambda'(S_{\mu-1}, S_\mu)) \qquad (12)$$

Daher wird zu jedem Zeitpunkt $\mu$ eine Zuverlässigkeitsinformation für den Zeitpunkt $\mu$-L' unter Verwendung einer reduzierten Anzahl von $2^{L'}$ unterschiedlichen Zuständen berechnet. Bei der vorliegenden Erfindung handelt es sich somit um einen supoptimalen Ansatz eines SDVE-Algorithmus mit reduzierter Zustandsanzahl.

**Patentansprüche**

1. Verfahren zum Erzeugen von Zuverlässigkeitsinformationen für die Kanaldecodierung in einem Funkempfänger, wobei die Zuverlässigkeitsinformationen (q) Wahrscheinlichkeiten dafür angeben, daß ein von dem Funkempfänger (7) über einen Funkkanal (6) empfangenes Datensymbol (z) auf einem ersten oder zweiten gesendeten Wert beruht,

wobei für jedes empfangene Datensymbol (z) zu einem beliebigen Zeitpunkt μ eine Zuverlässigkeitsinformation (q) für den Zeitpunkt μ-L' ermittelt wird, indem anhand eines Zustandsmodells mit $2^{L'}$ Zuständen ein erster Pfad, der zum Zeitpunkt μ-L' am wahrscheinlichsten den ersten Wert enthält, und ein zweiter Pfad, der zum Zeitpunkt μ-L' am wahrscheinlichsten den zweiten Wert enthält, ermittelt wird und für den ersten Pfad und den zweiten Pfad berechnete Metriken zueinander in Beziehung gesetzt werden, und
wobei die für den ersten Pfad und den zweiten Pfad berechneten Metriken in Abhängigkeit von einer ersten Gruppe von zu den Zeitpunkten μ ... μ-L' vorliegenden Symbolen und einer zweiten Gruppen von zu den Zeitpunkten μ-L'-1 ... μ-L vorliegenden Symbolen des Zustandsmodells berechnet werden und L mindestens der Länge der Kanalimpulsantwort des Funkkanals (6) mit L > L' entspricht,
**dadurch gekennzeichnet,**
**daß** zur Ermittlung der Zuverlässigkeitsinformation (q) für den Zeitpunkt μ-L' als Symbole der zweiten Gruppe Symbole verwendet werden, deren Wert vor dem Zeitpunkt μ-L' entschieden worden und für sämtliche Zustände des Zustandsmodells identisch ist.

2. Verfahren nach Anspruch 1,
   **dadurch gekennzeichnet,**
   **daß** die zu dem Zeitpunkt μ ermittelte Zuverlässigkeitsinformation (q) für den Zeitpunkt μ-L' in ein entsprechendes binäres Symbol umgesetzt und während der darauffolgenden L-L' Zeitpunkte als Symbol der zweiten Gruppe verwendet wird.

3. Verfahren nach Anspruch 2,
   **dadurch gekennzeichnet,**
   **daß** die zu dem Zeitpunkt μ ermittelte Zuverlässigkeitsinformation (q) für den Zeitpunkt μ-L' mittels einer Hard Decision in das entsprechende binäre Symbol umgesetzt wird.

4. Verfahren nach einem der vorhergehenden Ansprüche,
   **dadurch gekennzeichnet,**
   **daß** das Zustandsmodell durch eine Trellis-Darstellung realisiert ist.

5. Verfahren nach einem der vorhergehenden Ansprüche,
   **dadurch gekennzeichnet,**
   **daß** für die Metriken Matched-Filter-Metriken verwendet werden.

6. Verfahren nach Anspruch 5,
   **dadurch gekennzeichnet,**
   **daß** sich die Metrik λ' für einen Übergang von einem Zustand $S_{μ-1}$ zu einem Zustand $S_μ$ in dem Zustandsmodell zum Zeitpunkt μ gemäß der Formel berechnet

$$\lambda'(S_{\mu-1}, S_{\mu}) = -\mathrm{Re}\left\{ e_{\mu}\left( y_{\mu} - \sum_{l=1}^{L'} e_{\mu-l}\rho_{l} - \sum_{l=L'+1}^{L} e'_{\mu-l}\rho_{l} \right) \right\} \div \sigma^{2},$$

wobei $e_μ$ die Symbole der ersten Gruppe zum Zeitpunkt μ, $e_μ'$ die Symbole der zweiten Gruppe zum Zeitpunkt μ, $y_μ$ das Ausgangssymbol des verwendeten Matched Filters zum Zeitpunkt μ, $σ^2$ die Varianz der Rauschleistungsdichte des Funkkanals (6) und $ρ_1$ den 1-ten Wert der Autokorrelationsfunktion der Kanalimpulsantwort des Funkkanals (6) bezeichnet.

7. Verfahren nach einem der vorhergehenden Ansprüche,
   **dadurch gekennzeichnet,**
   **daß** das Verfahren in einem Mobilfunkempfänger (7) eines Mobilfunksystems angewendet wird.

8. Verfahren nach Anspruch 7,
   **dadurch gekennzeichnet,**
   **daß** das Verfahren in einem GSM-Mobilfunkempfänger (7) angewendet wird.

9. Funkempfänger,
   mit einem Entzerrer (8) zum Entzerren eines über einen Funkkanal (6) empfangenen Funksignals und zum Er-

**EP 1 198 890 B1**

zeugen von Zuverlässigkeitsinformationen (q) für einen nachgeschalteten Kanaldecodierer (10),

wobei die Zuverlässigkeitsinformationen (q) Wahrscheinlichkeiten dafür angeben, daß ein empfangenes Datensymbol (z) auf einem ersten oder zweiten gesendeten Wert beruht,

wobei der Entzerrer (8) derart ausgestaltet ist, daß er für jedes empfangene Datensymbol (z) zu einem beliebigen Zeitpunkt μ eine Zuverlässigkeitsinformation (q) für den Zeitpunkt μ-L' ermittelt, indem anhand eines Zustandsmodells mit $2^{L'}$ Zuständen ein erster Pfad, der zum Zeitpunkt μ-L' am wahrscheinlichsten den ersten Wert enthält, und ein zweiter Pfad, der zum Zeitpunkt μ-L' am wahrscheinlichsten den zweiten Wert enthält, ermittelt wird und für den ersten Pfad und den zweiten Pfad berechnete Metriken zueinander in Beziehung gesetzt werden, und

wobei der Entzerrer (8) derart ausgestaltet ist, daß er die für den ersten Pfad und den zweiten Pfad berechneten Metriken in Abhängigkeit von einer ersten Gruppe von zu den Zeitpunkten μ ... μ-L' vorliegenden Symbolen und einer zweiten Gruppen von zu den Zeitpunkten μ-L'-1 ... μ-L vorliegenden Symbolen des Zustandsmodells berechnet, wobei L mindestens der Länge der Kanalimpulsantwort des Funkkanals (6) mit L > L' entspricht,

**dadurch gekennzeichnet,**

**daß** der Entzerrer (8) derart ausgestaltet ist, daß er zur Ermittlung der Zuverlässigkeitsinformation (q) für den Zeitpunkt μ-L' als Symbole der zweiten Gruppe Symbole verwendet, deren Wert vor dem Zeitpunkt μ-L' entschieden worden und für sämtliche Zustände des Zustandsmodells identisch sind.

10. Funkempfänger nach Anspruch 9,
    **dadurch gekennzeichnet,**
    **daß** der Entzerrer (8) zur Durchführung des Verfahrens nach einem der Ansprüche 1-8 ausgestaltet ist.

**Claims**

1. A method for generating reliability information for channel decoding in a radio receiver,
   the reliability information (q) specifying probabilities of a data symbol (z) received by the radio receiver (7) via a radio channel (6) being based on a first or second transmitted value,
   a reliability information (q) for time μ-L' being determined at an arbitrary time μ for each received data symbol (z), by determining, by means of a state model having $2^{L'}$ states, a first path which most probably contains the first value at time μ-L' and a second path which most probably contains the second value at time μ-L' and putting metrics calculated for the first path and the second path into a relationship with one another, and
   the metrics calculated for the first path and the second path being calculated in dependence on a first group of symbols of the state model present at times μ...μ-L' and a second group of symbols of the state model present at times μ-L'-1...μ-L and L corresponding to at least the length of the channel impulse response of the radio channel (6) with L > L',
   **characterized in that**,
   for determining the reliability information (q) for time μ-L', symbols, the value of which has been decided before the time μ-L' and is identical for all states of the state model, are used as symbols of the second group.

2. The method as claimed in claim 1, **characterized in that** the reliability information (q) determined for the time μ is converted into a corresponding binary symbol for the time μ-L' and used as symbol of the second group during the subsequent L-L' times.

3. The method as claimed in claim 2, **characterized in that** the reliability information (q) determined at time μ is converted into the corresponding binary symbol by means of a hard decision for the time μ-L'.

4. The method as claimed in one of the preceding claims, **characterized in that** the state model is implemented by a trellis representation.

5. The method as claimed in one of the preceding claims, **characterized in that** matched-filter metrics are used for the metrics.

6. The method as claimed in claim 5, **characterized in that** the metric $\lambda'$ for a transition from a state $S_{\mu-1}$ to a state $S_\mu$ in the state model at time μ is calculated in accordance with the following formula:

$$\lambda'\left(S_{\mu-1}, S_{\mu}\right) = -Re\left\{e_{\mu}\left(y_{\mu} - \sum_{l=1}^{L'} e_{\mu-l}\rho_l - \sum_{l=L'+1}^{L} e'_{\mu-l}\rho_l\right)\right\} \div \sigma^2$$

where $e_{\mu}$ designates the symbols of the first group at time $\mu$, $e_{\mu}'$ designates the symbols of the second group at time $\mu$, $y_{\mu}$ designates the output symbol of the matched-filter used at time $\mu$, $\sigma^2$ designates the variance of the noise power density of the radio channel (6) and $\rho_1$ designates the l-th value of the autocorrelation function of the channel impulse response of the radio channel (6).

**7.** The method as claimed in one of the preceding claims, **characterized in that** the method is used in a mobile radio receiver (7) of a mobile radio system.

**8.** The method as claimed in claim 7, **characterized in that** the method is used in a GSM mobile radio receiver (7).

**9.** A radio receiver, comprising
an equalizer (8) for equalizing a radio signal received via a radio channel (6) and for generating reliability information (q) for a downstream channel decoder (10),
the reliability information (q) specifying probabilities of a received data symbol (z) being based on a first or second transmitted value,
the equalizer (8) being designed in such a manner that it determines for each received data symbol (z), at an arbitrary time $\mu$, a reliability information item (q) for the time $\mu$-L' by determining, by means of a state model with $2^{L'}$ states, a first path which most probably contains the first value at time $\mu$-L' and a second path which most probably contains the second value at time $\mu$-L' and putting metrics calculated for the first path and the second path in relationship with one another, and
the equalizer (8) being designed in such a manner that it calculates the metrics calculated for the first path and the second path in dependence on a first group of symbols of the state model present at times $\mu$...$\mu$-L' and a second group of symbols of the state model present at times $\mu$-L'-1...$\mu$-L, L corresponding to at least the length of the channel impulse response of the radio channel (6), with L > L',
**characterized in that**
the equalizer (8) is designed in such a manner that it uses for determining the reliability information (q) for the time $\mu$-L' symbols, the value of which has been decided before the time $\mu$-L' and is identical for all states of the state model, as symbols of the second group.

**10.** The radio receiver as claimed in claim 9, **characterized in that** the equalizer (8) is designed for carrying out the method as claimed in one of claims 1-8.

**Revendications**

**1.** Procédé de production d'informations de fiabilité destinées au décodage de canal dans un récepteur radio, dans lequel les informations de fiabilité (q) indiquent des probabilités selon lesquelles un symbole de données (z) reçu par le récepteur radio (7) par l'intermédiaire d'un canal radio (6) repose sur une première ou une deuxième valeur émise,
dans lequel, pour chaque symbole de données (z) reçu à n'importe quel instant $\mu$, une information de fiabilité (q) est déterminée pour le moment $\mu$, une première voie, qui, le plus probablement, comprend à l'instant $\mu$-L' la première valeur, et une deuxième voie, qui, le plus probablement, comprend à l'instant $\mu$-L' la deuxième valeur, étant déterminées à l'aide d'un modèle d'état avec des états $2^{L'}$, et des espaces métriques calculés pour la première voie et pour la deuxième voie étant mis en relation les uns avec les autres, et
dans lequel les espaces métriques calculés pour la première voie et pour la deuxième voie sont calculés en fonction d'un premier groupe de symboles du modèle d'état présents aux instants $\mu$ ... $\mu$-L' et d'un deuxième groupe de symboles du modèle d'état présents aux instants $\mu$-L'-1 ... $\mu$-L et L correspond au moins à la longueur de la réponse d'impulsion de canal du canal radio (6) avec L > L',
**caractérisé en ce que**
pour déterminer l'information de fiabilité (q) pour l'instant $\mu$-L', on utilise comme symboles du deuxième groupe des symboles dont la valeur a été décidée avant l'instant $\mu$-L' et est identique pour tous les états du modèle d'état.

**2.** Procédé selon la revendication 1,
> **caractérisé en ce que**
> l'information de fiabilité (q) déterminée à l'instant $\mu$ pour l'instant $\mu$-L' est convertie en un symbole binaire approprié et est utilisée comme symbole du deuxième groupe pendant les instants suivants L-L'.

**3.** Procédé selon la revendication 2,
> **caractérisé en ce que**
> l'information de fiabilité (q) déterminée à l'instant $\mu$ pour l'instant $\mu$-L' est convertie en le symbole binaire approprié à l'aide d'une Hard Decision.

**4.** Procédé selon l'une des revendications précédentes,
> **caractérisé en ce que**
> le modèle d'état est réalisé à l'aide d'une représentation en treillis.

**5.** Procédé selon l'une des revendications précédentes,
> **caractérisé en ce que**
> l'on utilise comme espaces métriques des espaces métriques Matched Filter.

**6.** Procédé selon la revendication 5,
> **caractérisé en ce que**
> l'espace métrique $\lambda'$ se calcule, pour une transition d'un état $S_{\mu-1}$ à un état $S_\mu$ dans le modèle d'état à l'instant $\mu$, selon la formule

$$\lambda'\left(S_{\mu-1}, S_\mu\right) = -Re\left\{ e_\mu \left( y_\mu - \sum_{l=1}^{L'} e_{\mu-l}\rho_l - \sum_{l=L'+1}^{L} e'_{\mu-l}\rho_l \right) \right\} \div \sigma^2 \;.$$

où $e_\mu$ désigne les symboles du premier groupe à l'instant $\mu$, $e_\mu'$ désigne les symboles du deuxième groupe à l'instant $\mu$, $Y_\mu$ désigne le symbole de départ du Matched Filter utilisé à l'instant $\mu$, $\sigma^2$ désigne la variance de la puissance volumique de bruit du canal radio (6) et $\rho1$ la l-ième valeur de la fonction d'autocorrélation de la réponse d'impulsion de canal du canal radio (6).

**7.** Procédé selon l'une des revendications précédentes,
> **caractérisé en ce que**
> le procédé est utilisé dans un récepteur radio mobile (7) d'un système radio mobile.

**8.** Procédé selon la revendication 7,
> **caractérisé en ce que**
> le procédé est utilisé dana un récepteur radio mobile (7) GSM.

**9.** Récepteur radio,
> avec un égalisateur (8) pour égaliser un signal radio reçu par l'intermédiaire d'un canal radio (6) et pour générer des informations de fiabilité (q) pour un décodeur de canal (10) placé en aval,
> dans lequel les informations de fiabilité (q) indiquent des probabilités selon lesquelles un symbole de données (z) reçu repose sur une première ou une deuxième valeur émise,
> dans lequel l'égalisateur (8) est conçu de manière à déterminer, pour chaque symbole de données (z) reçu à n'importe quel instant $\mu$, une information de fiabilité (q) pour l'instant $\mu$-L', une première voie, qui, le plus probablement, comprend à l'instant $\mu$-L' la première valeur, et une deuxième voie, qui, le plus probablement, comprend à l'instant $\mu$-L' la deuxième valeur, étant déterminées à l'aide d'un modèle d'état avec des états $2^{L'}$, et des espaces métriques calculés pour la première voie et pour la deuxième voie étant mis en relation les uns avec les autres, et
> dans lequel l'égalisateur (8) est conçu de manière à calculer les espaces métriques calculés pour la première voie et pour la deuxième voie en fonction d'un premier groupe de symboles du modèle d'état présents aux instants $\mu$ ... $\mu$-L' et d'un deuxième groupe de symboles du modèle d'état présents aux instants $\mu$-L'-1 ... $\mu$-L, L correspondant au moins à la longueur de la réponse d'impulsion de canal du canal radio (6) avec L > L',
> **caractérisé en ce que**
> l'égalisateur (8) est conçu de manière à utiliser, pour déterminer l'information de fiabilité (q), comme symboles du deuxième groupe des symboles dont la valeur a été décidée avant l'instant μ-L' pour l'instant μ-L' et qui sont identiques pour tous les états du modèle d'état.

10. Récepteur radio selon la revendication 9,
**caractérisé en ce que**
l'égalisateur (8) est conçu pour réaliser le procédé selon l'une de revendications 1 à 8.

# FIG 1

Quellen-codierer 2

$b$

Kanal-codierer 3

$c$

Interleaver 4

1

$d$

Formatierer 5

$e$

HF-Kanal 6

$z$

Kanal-decodierer 10

$q$

Deinterleaver 9

7

Entzerrer 8

# FIG 2

$e_m$

$e_{m-1}$ 11

$e_{m-2}$ 11

$e_{m-L}$ 11

6

$h0$ 12

$h1$ 12

$h2$ 12

$hL$ 12

$\Sigma$ 13

14

AWGN

$z_m$

**FIG 3A**

Zeitschritt μ →

m    m+1    m+2

Zustand Sμ ↓

0,0

1,0

$e_m = 1$

0,1

1,1

$\Lambda_b (0,0)$

$\lambda (1,0; 0,0)$

$\Lambda_f (1,0)$

$\Lambda_b (1,0)$

$\lambda (1,0; 0,1)$

$\Lambda_b (0,1)$

$\lambda (1,1; 1,0)$

$\lambda (1,1; 1,1)$

$\Lambda_b (1,1)$

$\Lambda_f (1,1)$

**FIG 3B**

Zeitschritt μ →

$\Lambda_f (0,0)$

m    m+1    m+2

Zustand Sμ ↓

0,0

1,0

$e_m = 0$

0,1

1,1

$\Lambda_b (0,0)$

$\lambda (0,0; 0,0)$

$\lambda (0,0; 0,1)$

$\Lambda_b (1,0)$

$\lambda (0,1; 1,0)$

$\Lambda_b (0,1)$

$\Lambda_f (0,1)$

$\lambda (0,1; 1,1)$

$\Lambda_b (1,1)$